# EUROPÄISCHE PATENTSCHRIFT

(11) **EP 1 554 724 B1**
(45) Veröffentlichungstag und Bekanntmachung des Hinweises auf die Patenterteilung: **14.01.2009**
(21) Anmeldenummer: 03809254.0
(22) Anmeldetag: 12.08.2003
(51) Int. Cl.: G11B 7/24, B41M 5/26, C03C 21/00, G11C 13/04, C03C 4/00

(54) **SPEICHERMEDIUM**
STORAGE MEDIUM
SUPPORT D'INFORMATIONS

(30) Priorität: 21.10.2002 DE 10249095
(43) Veröffentlichungstag der Anmeldung: 20.07.2005
(73) Patentinhaber: Fehr, Gerhard, 57533 Kleve (DE); boraident GmbH, 06118 Halle/Saale (DE)
(72) Erfinder: CIOC, Alexander, 47533 Kleve (DE); FEHR, Gerhard, 47533 Kleve (DE); BOREK, Reinhard, 06110 Halle (DE); RAINER, Thomas, 38855 Wernigerode (DE); SCHNEIDER, Jochen, 06132 Halle (DE); BERG, Klaus-Jürgen, 06130 Halle (DE); BERG, Gunnar, 06108 Halle (DE)
(74) Vertreter: COHAUSZ DAWIDOWICZ HANNIG & SOZIEN
(86) Internationale Anmeldenummer: PCT/EP2003/008920
(87) Internationale Veröffentlichungsnummer: WO 2004/038713

(56) Entgegenhaltungen:
- DE-A- 10 119 302
- DE-A- 19 724 214
- DE-A- 19 841 547
- FR-A- 2 801 302
- US-A- 4 811 289

## Beschreibung

Die Erfindung betrifft ein Speichermedium zur Speicherung von Informationen/Daten sowie ein Verfahren zum Speichern und/oder Lesen von Daten in Verbindung mit einem solchen Speichermedium.

Speichermedien zur Speicherung von Informationen und Daten sind hinlänglich bekannt. Zur Archivierung größerer Datenmengen wird in Computeranwendungen beispielsweise häufig auf einfach oder mehrfach beschreibbare CDs oder DVDs zurückgegriffen, deren Grundprinzip darauf beruht, dass in eine auf einer Trägerscheibe angeordneten Farbstoffschicht mittels eines Laserstrahles durch Veränderung der Farbstoffmoleküle eine Information eingeschrieben bzw. eine eingeschriebene Information ausgelesen wird. Neben der technisch begrenzten Speicherkapazität derartiger bekannter Speichermedien ist ein gravierender Nachteil die Tatsache, dass die Farbstoffzusammensetzung bei den bekannten Speichermedien nicht alterungsbeständig sind und insbesondere unter UV-Lichtbestrahlung, beispielsweise durch einfallendes Sonnenlicht zerfallen, so dass im Lauf der Zeit die gespeicherten Daten der Gefahr eines Verlustes unterliegen.

Darüber hinaus werden als Trägermaterialien für CDs und DVDs häufig Kunststoffscheiben verwendet, die eine besondere Empfindlichkeit gegen Kratzer aufweisen, so dass bei einer unsachgemäßen Handhabung ein Verlust der Daten auch durch mechanische Beschädigung der Speichermedien auftreten kann.

Aufgabe der Erfindung ist es ein Speichermedium und ein damit verbundenes Verfahren zur Speicherung bzw. zum Auslesen von Daten bereitzustellen, welche eine besonders gute Sicherheit vor Datenverlust aufgrund mechanischer oder Alterungsschäden zur Verfügung stellt und darüber hinaus eine hohe Datendichte zur Verfügung stellt.

Diese Aufgabe wird erfindungsgemäß durch ein Speichermedium gelöst, welches ein dielektrisches, insbesondere scheibenförmiges Speichermaterial umfasst, auf dem wenigstens einseitig ein Spendermedium für Metallionen angeordnet oder anbringbar ist. Bei einem solchen Speichermedium kann es sich bevorzugt um ein Glas, insbesondere Flachglas handeln.

Bei einem solchen Speichermedium besteht die Möglichkeit mittels Bestrahlung dieses Speichermediums durch elektromagnetische und/oder Teilchen-Strahlung, insbesondere mittels Laserstrahlung, eine zumindest lokale Dotierung des Speichermediums durch Metallionen hervorzurufen, die aufgrund der Bestrahlung und einer dadurch hervorgerufenen Erwärmung des Speicher- und Spendermediums von dem Spendermedium in das Speichermedium herüberdiffendieren.

Für diese Art der Metallionendotierung werden bevorzugt Silber-, Gold-, Platin oder Kupferionen oder beliebige Kombinationen hieraus eingesetzt. Diese Metallionen können sich in einem Spendermedium befinden, welches zumindest einseitig auf dem Speichermedium bzw. Speichermaterial angeordnet oder anbringbar ist, wobei das Spendermedium auf beliebige Arten und Weisen auf dem dielektrischen Speichermaterial angebracht sein kann. Beispielsweise besteht die Möglichkeit das Speichermaterial durch eine metallionenhaltige Folie zu bekleben oder aber z.B. im Druckverfahren das Spendermedium auf das Speichermedium aufzubringen.

Somit kann das Spendermedium sowohl schon bei der Herstellung des Speichermediums oder auch später durch einen Benutzer am Speichermedium angebracht werden.

Insbesondere bei einer lokal begrenzten Bestrahlung des Speichermediums z.B. mittels einer fokussierten Strahlung, insbesondere mittels fokussierter Laserstrahlung, können an den Orten der lokalen Erwärmung lokal die Metallionen in hoher Konzentration vom Spendermedium in das Speichermedium übertragen werden, wo sich die Metallionen insbesondere oberflächennah anordnen.

Verglichen mit bekannten Speicherverfahren, beispielsweise bei CDs oder DVDs kann ebenso mit einem derart erfindungsgemäßen Speichermedium eine Information in das dielektrische Medium eingeschrieben werden, die erfindungsgemäß dann aus dem Fehlen oder Vorhandensein einer Ansammlung von Metallionen innerhalb des dielektrischen Speichermaterials besteht. Bei einer z.B. rotierenden Bewegung eines scheibenförmigen Speichermediums unter einem Schreiblesestrahl können die Informationen z.B. nachfolgend auf einer Spiralbahn in das Speichermedium durch lokale Dotierung eingebracht werden.

Alleine schon die lokal eingebrachten Metallionen, wobei sich der lokale Bereich maßgeblich durch die Fleckgröße des Strahles im Speichermedium am Speicherort bestimmt, stellen eine Information dar, da sich durch die lokale Konzentrationserhöhung an Metallionen der Brechungsindex des Speichermediums an dieser Stelle ändert, so dass eine derart abgespeicherte Information auch auf einfache Art und Weise z.B. durch denselben Schreibstrahl, gegebenenfalls mit einer anderen Intensität ausgelesen werden kann, weil es in Reflektion oder Transmission zu Phasenverschiebungen des Strahles im Bereich der gespeicherten Informationen kommt.

Hier besteht durch mehr oder weniger starke Dotierung auch die Möglichkeit, nicht nur digital Informationen, sondern auch analoge Informationen zu speichern, da die Stärke der Dotierung z.B. von der Intensität und Dauer der Bestrahlung abhängig gemach werden kann.

Die Übertragung der Metallionen von dem Spendermedium in das Speichermedium erfolgt bevorzugt in einem Tieftemperaturbereich, wobei dieser durch Temperaturen unterhalb der Transformationstemperatur des dielektrischen Materials, also z.B. eines Glases, gegeben ist. Hierbei ist die Transformationstemperatur z.B. eines Glases gegeben durch die Temperatur, bei der die elastischen Eigenschaften des Glases in viskoelastische Eigenschaften übergehen. Unterhalb dieser Grenztemperatur, die für Flachglas beispielsweise bei ca. 530 Grad Celsius liegt, können effektiv mit der oben beschriebenen Methode Metallionen in das dielektrische Medium, insbesondere ein Glas, dotiert werden.

In einer weiteren oder alternativen Ausführung besteht die Möglichkeit durch eine lokale oder gleichmäßige Temperaturerhöhung des dielektrischen Speichermateriales oberhalb der Transformationstemperatur eine Reduktion der im Speichermedium vorhandenen Metallionen zu metallischen Partikeln durchzuführen. Nach einer solchen Reduktion besteht dementsprechend die in das Metall eingeschriebenen Informationen aus bereichsweisen Anordnungen von metallischen Clustern mit insbesondere sphärischer Gestalt innerhalb des Speichermediums. Auch durch diese metallischen Clusteranordnungen innerhalb des Speichermediums ändern sich die optischen Eigenschaften des Speichermediums sowohl in Reflektion und Transmission z.B. durch Verfärbung, so dass auch diese Art der Speicherung für eine langlebige Datenarchivierung verwendet werden kann, da sowohl die zuvor beschriebenen Metallionenansammlungen als auch die Metallatomansammlungen langzeitstabil und im Wesentlichen unempfindlich gegen üblichen alltäglichen Lichteinfall sind.

Allgemein erfolgt die Reduktion der in einem Speichermaterial vorhandenen Metallionen durch eine Erhitzung des dielektrischen Materiales oberhalb der Transformationstemperatur, so dass diese Reduktion z.B. durch eine gleichmäßige Erhitzung, d.h. Temperung des gesamten Speichermediums oberhalb dieser Temperatur nach einer zuvor erfolgten lokalen Informationsübertragung in Form von Metallionen erfolgen kann.

Alternativ ist es ebenso möglich die Speicherung von Informationen derart durchzuführen, dass in einem ersten Prozess mittels einer elektromagnetischen oder Teilchenbestrahlung die Metallionen aus einem Spendermedium lokal in das Speichermaterial übertragen werden und dann in einem zweiten Verfahrensschritt durch Erhöhung der Temperatur oberhalb der Transformationstemperatur, z.B. durch Erhöhung der Bestrahlungsintensität, die Metallionen zu Metallatomen reduziert werden. Dotierung und Reduzierung kann dementsprechend mit ein- und demselben Strahl, beispielsweise mit einem fokussierten Laserstrahl, erfolgen. Beide Prozeßschritte können z.B. unmittelbar nacheinander bei der Bestrahlung stattfinden, bei der das Speichermedium erwärmt wird, wobei unterhalb der Transformationstemperatur die Dotierung und nach Überschreiten der Transformationstemperatur die Reduktion erfolgt.

Unabhängig von dem zuvor beschriebenen Verfahren und Speichermedium besteht alternativ oder in Kombination mit dem zuvorgenannten die Möglichkeit ein Speichermedium zu verwenden, welches bereits eine insbesondere gleichmäßige Metallionendotierung aufweist, bei dem also die Metallionendotierung bereits im Herstellungsprozess des Speichermediums in dieses eingebracht wird. Bei einem solchen Speichermedium kann das Spendermedium, welches die Metallionen enthält, in Entfall kommen oder zusätzlich verwendet werden.

Gemäß einem erfindungsgemäßen Verfahren mit einem solchen Speichermedium kann eine Speicherung der Informationen z.B. dadurch erfolgen, dass durch Bestrahlung, beispielsweise mit elektromagnetischer oder Teilchenbestrahlung, insbesondere mit Laserstrahlung, die z.B. gleichmäßig innerhalb des Speichermaterials vorhandenen Metallionen im Bereich der lokalen Strahlungszone in Metallpartikel und/oder Metallpartikelansammlungen überführt werden. Hierfür ist im Wesentlichen sicherzustellen, dass durch die verwendete Strahlung im Bereich der gewünschten Speicherzone eine lokale Erhitzung des dielektrischen Speichermaterials oberhalb der Transformationstemperatur erfolgt oder eine sonstige geeignete Energieübertragung stattfindet.

Durch diese dann durchgeführte Reduktion der Metallionen zu Metallpartikeln oder Metallpartikelansammlungen ergibt sich dementsprechend die bereits oben beschriebene Informationsspeicherung innerhalb des Speichermediums.

Insbesondere in Gläsern als dielektrische Speichermaterialien kann die stattfindende Reduktion oberhalb der Transformationstemperatur durch die üblicherweise innerhalb des Glases vorliegenden metallischen Oxyde, wie z.B. Eisenoxyd und Zinnoxyd erklärt werden. Durch diese im Glas vorkommenden Metalloxyde ergeben sich niederwertige Metallionen, die in der Lage sind die durch die zuvor beschriebenen Prozesse eingebrachten Metallionen zu oxydieren und somit als natürlich vorliegende Reduktionsmittel zu wirken. Dieser Effekt ist insbesondere bei Flachglas signifikant, welches beispielsweise auf einem Zinnbad ausgegossen wird und dementsprechend zumindest auf einer Seite eine sehr hohe Zinnionenkonzentration aufweist.

Neben der Möglichkeit die Reduktion durch glaseigene Reduktionsmittel und lokale bzw. gleichmäßige Temperaturerhöhung oberhalb der Transformationstemperatur durchzuführen, besteht auch eine Möglichkeit zur Reduktion der Metallionen durch äußere Reduktionsmittel. Insbesondere Silberionen können effektiv in einer Wasserstoffatmosphäre durch die Difusion des Wasserstoffs in das Glas reduziert werden. Es besteht dementsprechend die Möglichkeit in einem Speichermedium, in welchem die Information durch lokale Metallionendotierung vorliegt, durch anschließende Temperung in einer Wasserstoffatmosphäre die lokalen Ionenansammlungen in Metallpartikelansammlungen zu überführen.

Für die Bestrahlung zur Erzielung der oben genannten Effekte einer lokalen Dotierung bzw. lokalen Reduktion der Metallionen können beliebige Strahlungsarten zum Einsatz kommen, wie z.B. elektromagnetische Strahlung, insbesondere Laserstrahlung, Gamma-, Röntgen-, Materie-, Ionen-Strahlung etc.

Für das Schreiben und Lesen der Informationen mittels eines Laserstrahls können bevorzugt CO₂-Laser wie auch Laser im sichtbaren Bereich, insbesondere im blauen Wellenlängenbereich zum Einsatz kommen. Gerade durch die Bestrahlung eines Speichermediums mit CO₂-Laserstrahlung im langwelligen Infrarotbereich können effektiv lokale Erwärmungen des Glases oder allgemein des dielektrischen Mediums erzeugt werden. Jedoch ist im Falle der Verwendung eines CO₂-Laserstrahles die Informationsdichte durch die sehr lange Wellenlänge begrenzt.

Vorteilhafter ist die Verwendung kürzerwelliger Laserstrahlung, die eine höhere Informationsdichte erlaubt, beispielsweise im blauen Wellenlängenbereich. Gerade dieser Wellenlängenbereich bietet sich in idealer Weise an, da zunächst durch eine lokale Erhitzung des Materials Metallkeime, insbesondere Silberatomkeime, ausgebildet werden können aufgrund des voranbeschriebenen Reduktionsprozesses, wobei dann weiterhin nach der Bildung von insbesondere sphärischen Metallpartikelkeimen eine Anhäufung von Metallatomen erfolgt. Die Größe einer solchen Agglomeration kann insbesondere durch die Bestrahlungsdauer und -intensität beeinflusst werden.

Die Verwendung eines blauen Laserstrahles bietet sich vorliegend besonders an, da durch die Existenz des sphärischen Metallpartikels innerhalb des Speichermaterials eine optische Polarisation dieser Teilchen, d.h. die Anregung einer kollektiven Schwingung der Leitungselektronen gegenüber den Atomrümpfen innerhalb der Metallpartikel hervorgerufen wird. Diese Kollektivschwingungen werden als Oberflächenplasmonen bezeichnet, wobei sich insbesondere für das Metall Silber im blauen Wellenlängenbereich Absorptionsresonanzen ergeben, so dass die Metallpartikelbildung auch durch eine Resonanzabsorption der blauen Wellenlänge durch eine solche Oberflächenplasmonenresonanz besonders effektiv durchgeführt werden kann.

Durch eine derart resonanzerhöhte Strahlungsabsorption kann dementsprechend nach der Reduktion von Metallionen zu einem Metallpartikelkeim ein solcher Keim zu einer großen Metallpartikelansammlung effektiv anwachsen.

Nach einer Speicherung gewünschter Informationen kann ebenfalls eine Löschung dieser Informationen nachträglich dadurch erfolgen, dass das Speichermedium in besonderem Maße erhitzt wird und sich somit eine statistische Verteilung der im Speichermaterial vorhandenen Partikel einstellt, die keine weitere Informationswiedergabe ermöglicht.

In einer bevorzugten Weiterbildung des erfindungsgemäßen Speichermaterials ist dieses zumindest einseitig mit einer weiteren Materialschicht versehen, beispielsweise einem Polymer. Eine solche Materialschicht kann beispielsweise als Schutzschicht dienen.

Alternativ oder ergänzend zur Schutzfunktion besteht weiterhin die Möglichkeit, dass die Materialschicht eine optisch funktionale Struktur aufweist. Beispielsweise kann in der Materialschicht eine Information vorgesehen sein, die zur Führung eines Schreiblesestrahles eingesetzt werden kann. Eine entsprechende Vorrichtung zum Beschreibung und zum Lesen der erfindungsgemäßen Speichermedien kann dementsprechend einem Schreib- oder Lesestrahl, beispielsweise einem Laserstrahl, anhand der in der zusätzlichen Materialschicht vorhandenen Information über die Oberfläche des Speichermediums führen und hierbei Daten in das Medium durch die zuvor beschriebenen Prozesse einschreiben oder aber auch gespeicherte Daten auslesen.

Da bei den zuvor beschriebenen Möglichkeiten der lokalen oder auch gleichmäßigen Dotierung eines dielektrischen Speichermateriales mit Metallionen diese Metallionendotierung wenigstens einseitig insbesondere oberflächennah im Speichermaterial angeordnet ist, empfiehlt es sich in einer bevorzugten Ausführung, dass die Materialschicht, die als Schutzschicht und/oder als zusätzliche Informationsschicht dienen kann, auf derjenigen Oberfläche des Speichermediums angeordnet wird, die die oberflächennahe Metallionendotierung aufweist. Hierdurch wird gleichzeitig ein effektiver Schutz dieser Metallionendotierung in der Oberfläche des Speichermaterials erreicht.

Die Anordnung wenigstens einer weiteren Materialschicht auf einem Speichermaterial kann in bevorzugter Weise dadurch erfolgen, dass das Speichermedium wenigstens zwei miteinander verbundene Scheiben aufweist, von denen wenigstens eine ein Speichermaterial umfasst und eine andere eine oben beschriebene Materialschicht ausbildet. Derartige Scheiben oder Schichten können in beliebiger Weise übereinandergestapelt werden, so dass hierdurch auch mehrschichtige Speichermedien ausgebildet werden können, die eine Abspeicherung von Informationen in verschiedenen tiefen Ebenen erlauben. Hierbei kann die entsprechende Schreib- oder Leseebene insbesondere durch eine Verlagerung des Fokus der verwendeten Strahlung innerhalb des Speichermediums selektiert werden.

Ein besonderer Schutz ergibt sich bei diesem Schichtaufbau auch dadurch, dass die funktionale Struktur in der Materialschicht auf der dem Speichermaterial zugewandten Seite dieser Materialschicht angeordnet ist. In Verbindung mit der oben beschriebenen bevorzugten Ausführung können dementsprechend sowohl die oberflächennahe Metallionendotierung als auch die gegebenenfalls funktionale Struktur in der Materialschicht einander direkt gegenüberliegen und somit innerhalb der beiden Materialien, d.h. einerseits der gegebenenfalls schützenden Materialschicht und andererseits dem dielektrischen Material eingekapselt sein. Durch diese innere Verkapselung ergibt sich ein besonders guter Schutz gegen mechanische Beschädigung sowohl der funktionalen Struktur als auch der innerhalb der Dotierungsschicht abgelegten Information.

Insbesondere für ein vereinfachtes Auslesen der gespeicherten Information kann es vorgesehen sein, dass das Speichermedium eine Reflektionsschicht aufweist, die insbesondere an der Materialschicht, bevorzugt zwischen einer Materialschicht und einem Speichermaterial, angeordnet ist. Diese Reflektionsschicht kann besonders vorteilhaft die funktionale Struktur, beispielsweise Führungsspur für ein Schreib- oder Leselaser, bedecken und so die Abtastung dieser funktionalen Struktur vereinfachen, wobei gleichzeitig die Reflektionsschicht ein Auslesen der gespeicherten Information in einer Reflektionsanordnung ermöglicht.

Ein Ausführungsbeispiel der Erfindung ist in der nachfolgenden Figur näher erläutert.

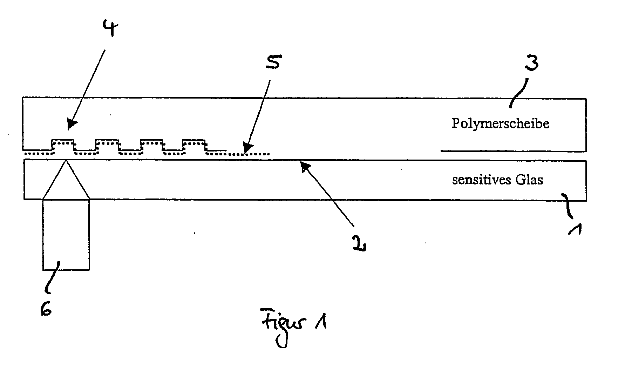

Die Figur 1 zeigt ein erfindungsgemäßes Speichermedium, welches als Hybrid-Speichermedium bezeichnet werden kann und aus einem ersten scheibenförmigen sensitiven dotierten Glas 1 und einer zweiten darüber in Laserstrahlrichtung hinter dem Glas angeordneten Polymerscheibe 3 besteht. Die Glasscheibe 1 umfasst im Bereich ihrer Oberfläche 2 eine Metallionendotierung, die z.B. bereits beim Herstellungsprozess in das Glas in gleichmäßiger Form eingebracht wurde.

Die Polymerscheibe 3 dient als Schutzscheibe für die oberflächennah angeordnete Metallionendotierung innerhalb der Glasscheibe 1 und trägt weiterhin auf ihrer der Glasscheibe 1 zugewandten Oberfläche eine optisch funktionale Struktur in der Form einer Führungsspur 4, die sich beispielsweise spiralförmig bezüglich des Mittelpunktes der beiden Scheiben über die gesamte innere Oberfläche der Polymerscheibe 3 erstreckt. Die innere Oberfläche der Polymerscheibe 3, die der die Metallionen enthaltene Oberfläche 2 des Glases zugewandt ist, trägt weiterhin eine Reflektionsschicht 5, z.B. aus Aluminium, die sich gleichmäßig über die Polymerscheibe und die darin angeordnete funktionale Struktur erstreckt. Hierdurch wird eine besonders einfache Führung eines Schreibleselasers 6 in einer Reflektionskonfiguration, wie Sie beispielsweise auch von üblichen CDs und DVDs bekannt ist, ermöglicht.

Durch die Tatsache, dass sowohl die die Metallionendotierung aufweisende Oberfläche 2 des Glases als auch die die funktionale Struktur aufweisende Oberfläche der Polymerscheibe aufeinander zugewandt sind und auch die Reflektionsschicht im Inneren dieses Verbundes zu liegen kommt, ergibt sich ein besonders guter Schutz gegen mechanische Beschädigung dieser drei Anordnungen. In einer Aufnahmevorrichtung zur Verwendung eines solchen erfindungsgemäßen Speichermediums kann der hier dargestellte Schreiblaserstrahl 6 anhand der Führungsspur 4 geführt werden, so dass in einer Spiralform die gewünschten Informationen innerhalb des Speichermediums, d.h. im Bereich der Oberfläche 2 der Glasscheibe 1 abgelegt werden können.

Beim Durchgang des Schreiblaserstrahles durch die Glasschicht der Speicherplatte 1 wird der Laserstrahl gebrochen und durch die vorgeschaltete Optik so abgestimmt, dass der Fokus in der gewünschten Schreibebene, d.h. nahe der Oberfläche 2 des Speichermediums 1 zu liegen kommt. Bevorzugt bildet die Glasoberfläche an der Kontaktstelle zum Polymer, d.h. an der Reflektionsschicht, die gewünschte Schreibebene. Es besteht ebenso die Möglichkeit diese Schreibebene mehr in das Innere der Glasscheibe 1 zu verlegen.

Durch die lokale Erhitzung des Speichermediums 1 im Bereich der Schreibebene vollzieht sich der oben beschriebene Reduktionsprozess, so dass die gleichmäßig vorliegenden Metallionen lokal im Bereich der Erhitzung reduziert werden und hierdurch die Information im Speichermedium abgelegt wird. Insbesondere bei dieser Konfiguration ergibt sich durch die Reduktion der Metallionen zu Metallpartikeln eine Färbung des Glases im Bereich des Fokus, die dann in Reflektion oder Transmission in einfacher Weise zum wiederholbaren Auslesen der abgelegten Information verwendet werden kann.

Aufgrund der Unempfindlichkeit sowohl der Metallionen als auch der Metallpartikel nach der Reduktion ergibt sich eine besonders gute Langzeitstabilität, die die Stiblität üblicher farbstoffbasierter Speichermedien bei weitem überschreitet.

## Patentansprüche

1. Speichermedium zur Speicherung von Informationen/Daten **dadurch gekennzeichnet dass** das Speichermedium ein dielektrisches, scheibenförmiges Speichermaterial (1) umfasst auf dem wenigstens einseitig ein Spendermedium für Metallionen angeordnet ist, wobei durch Bestrahlung des Speichermediums mit Laserstrahlung (6), Metallionen vom Sender medium in das Speichermaterial (1) übertragbar sind.

2. Speichermedium zur Speicherung von Informationen/Daten, insbesondere nach Anspruch 1, **dadurch gekennzeichnet, dass** das Speichermedium ein dielektrisches, scheibenförmiges Speichermaterial (1) umfasst, welches eine zumindest lokale Metallionen-Dotierung aufweist, wobei durch Bestrahlung mit Laserstrahlung (6) die Metallionen in Metallpartikel und oder Metallpartikelansammlungen überführbar sind.

3. Speichermedium nach Anspruch 1 oder 2, **dadurch gekennzeichnet, dass** es sich bei dem Speichermaterial (1) um Glas handelt.

4. Speichermedium nach einem der vorherigen Ansprüche, **dadurch gekennzeichnet, dass** die Metallionendotierung wenigstens einseitig oberflächennah im Speichermaterial (1) angeordnet ist.

5. Speichermedium nach einem der vorherigen Ansprüche, **dadurch gekennzeichnet, dass** die Metalldotierung mit Silber- und/oder Gold- und/oder Platin- und/oder Kupferionen ausgerührt ist.

6. Speichermedium nach einem der vorherigen Ansprüche, **dadurch gekennzeichnet, dass** auf dem Speichermaterial (1) wenigstens einseitig eine Materialschicht (3), insbesondere aus Polymer, angeordnet ist.

7. Speichermedium nach einem der vorherigen Ansprüche, **dadurch gekennzeichnet, dass** die Materialschicht (3) eine optisch funktionale Struktur (4) aufweist, die insbesondere eine Information zur Führung eines Schreib-/Lese-Strahles (6) bildet.

8. Speichermedium nach einem der vorherigen Ansprüche, **dadurch gekennzeichnet, dass** es wenigstens zwei miteinander verbundene Scheiben (1,3) aufweist, von denen wenigstens eine ein Speichermaterial (1) umfasst und eine andere eine Materialschicht (3) ausbildet.

9. Speichermedium nach einem der vorherigen Ansprüche, **dadurch gekennzeichnet, dass** eine oberflächennahe Metallionen-Dotierung auf der der Materialschicht (3) zugewandten Seite eines Speichermateriales (1) angeordnet ist.

10. Speichermedium nach einem der vorherigen Ansprüche, **dadurch gekennzeichnet, dass** die funktionale Struktur (4) in der Materialschich (3) auf der einem Speichermaterial (1) zugewandten Seite angeordnet ist.

11. Speichermedium nach einem der vorherigen Ansprüche, **dadurch gekennzeichnet, dass** es eine Reflexionschicht (5) aufweist, die insbesondere an der Materialschicht (3), bevorzugt zwischen der Materialschicht (3) und dem Speichermaterial (1) angeordnet ist.

12. Speichermedium nach einem der vorherigen Ansprüche, **dadurch gekennzeichnet, dass** die gespeicherten Informationen/Daten aus einer räumlichen Anordnung von Speichermaterialbereichen mit und ohne Metallpartikeln/Metallionen besteht,

13. Verfahren zum Speichern und/oder Lesen von Daten mit einem Speichermedium, insbesondere nach einem der vorherigen Ansprüche, **dadurch gekennzeichnet, dass** mittels Bestrahlung des Speichermediums/- materials durch elektromagnetische und/oder Teilchen-Strahlung eine Dotierung des Speichermediums/-materials (1) durch Metallionen von einem auf dem Speichermedium/-material (1) angeordneten Spendermedium durchgeführt wird.

14. Verfahren zum Speichern und/oder Lesen von Daten mit einem Speichermedium, insbesondere nach einem der vorherigen Ansprüche **dadurch gekennzeichnet, dass** mittels Bestrahlung des Speichermediums/- materials (1) durch elektromagnetische und/oder Teilchen-Strahlung in einem zumindest lokal mit Metallionen dotierten dielektrischen Speichermaterial (1) durch lokale Metallpartikelbildung aus Metallionen eine Information im Speichermaterial (1) gespeichert wird und/oder eine durch lokal gebildete Metallpartikel gespeicherte Information durch Abtastung des Speichermaterials (1) mit der genannten Strahlung in Transmission und/oder Reflexion ausgelesen wird.

15. Verfahren nach einem der vorherigen Ansprüche, **dadurch gekennzeichnet, dass** das Schreiben und Lesen der Informationen mit einem Laserstrah (6) im sichtbaren Spektralbereich, insbesondere im blauen Wellenlängenbereich erfolgt.

16. Verfahren nach einem der vorherigen Ansprüche, **dadurch gekennzeichnet, dass** die Bildung von Metallpartikeln und/oder Metallpartikelansammlungen in einem ersten Schritt bei Bestrahlung durch thermisch induzierte Bildung von Metallpartikelkeimen durch Reduktion von Metallionen erfolgt und in einem zweiten Schritt ein Wachstum der Metallpartikelkeime zu einer Metallpartikelansammlung durch resonanzerhöhte Strahlungsabsorption, insbesondere aufgrund einer Oberflächenplasmonenresonanz, erfolgt.

17. Verfahren nach einem der vorherigen Ansprüche, **dadurch gekennzeichnet, dass** eine Löschung der gespeicherten Informationen/Daten durch eine Erhitzung des Speichermediums (1), erfolgt.

## Claims

1. Storage medium for storing information/data, **characterised in that** the storage medium comprises a dielectric, disc shaped storage material (1), on at least one side of which a dispensing medium for metal ions is arranged, in which metal ions may be transferred from the dispensing medium into the storage material (1) by irradiating the dispensing medium with laser radiation (6).

2. Storage medium for storing information/data, particularly according to claim 1, **characterised in that** the storage medium comprises a dielectric, disc shaped storage material (1), which has at least local metal ion doping, in which the metal ions may be converted into metal particles and/or aggregations of metal particles by irradiating with laser radiation (6).

3. Storage medium according to claim 1 or 2, **characterised in that** the storage material (1) is glass.

4. Storage medium according to one of the previous claims, **characterised in that** the metal ion doping is arranged on at least one side near the surface in the storage material (1).

5. Storage medium according to one of the previous claims, **characterised in that** the metal doping may be carried out with silver and/or gold and/or platinum and/or copper ions.

6. Storage medium according to one of the previous claims, **characterised in that** a layer of material (3), particularly made of polymer, is arranged on at least one side on the storage material (1).

7. Storage medium according to one of the previous claims, **characterised in that** the layer of material (3) has an optically functional structure (4), which forms information particularly to guide a writing/reading beam (6).

8. Storage medium according to one of the previous claims, **characterised in that** it has at least two discs connected to each other (1, 3), of which at least one comprises a storage material (1) and another forms a layer of material (3).

9. Storage medium according to one of the previous claims, **characterised in that** metal ion doping near the surface is arranged on the side of a storage material (1) facing the layer of material (3).

10. Storage medium according to one of the previous claims, **characterised in that** the functional structure (4) in the layer of material (3) is arranged on the side facing the storage material (1).

11. Storage medium according to one of the previous claims, **characterised in that** it has a reflecting layer (5), which is arranged preferably between the layer of material (3) and the storage material (1), particularly on the layer of material (3).

12. Storage medium according to one of the previous claims, **characterised in that** the stored information/data consists of a spatial arrangement of storage material areas with and without metal particles/metal ions.

13. Method for storing and/or reading data with a storage medium, particularly according to one of the previous claims, **characterised in that** doping of the storage medium/material (1) by metal ions from a dispensing medium arranged on the storage medium/material (1) is carried out by means of irradiating the storage medium/material by electromagnetic and/or particle radiation.

14. Method for storing and/or reading data with a storage medium, particularly according to one of the previous claims, **characterised in that** information is stored in the storage material (1) by means of irradiating the storage medium/material (1) by electromagnetic and/or particle radiation in a dielectric storage material (1) doped at least locally with metal ions by local metal particle formation from metal ions and/or information stored by locally formed metal particles is read by scanning the storage material (1) with the radiation indicated in transmission and/or reflection.

15. Method according to one of the previous claims, **characterised in that** writing and reading information with a laser beam (6) is carried out in the visible spectral range, particularly in the blue wavelength range.

16. Method according to one of the previous claims, **characterised in that** the formation of metal particles and/or aggregations of metal particles is carried out in a first step when irradiating by the thermally induced formation of metal particle nuclei by the reduction of metal ions and the growth of the metal particle nuclei into an aggregation of metal particles is carried out in a second step by increased resonance radiation absorption, particularly based on surface plasmon resonance.

17. Method according to one of the previous claims, **characterised in that** deletion of the stored information/data is carried out by heating the storage medium (1).

## Revendications

1. Support de mémoire pour le stockage d'informations et de données, **caractérisé en ce que** le support de mémoire comporte un matériau d'enregistrement (1) diélectrique en forme de disque, sur au moins une face duquel est disposé un milieu de distribution pour des ions métalliques, sachant que sous l'effet de l'irradiation du support de mémoire par un rayon laser (6), des ions métalliques peuvent être transmis depuis le milieu de distribution dans le matériau d'enregistrement (1).

2. Support de mémoire pour le stockage d'informations et de données, en particulier selon la revendication 1, **caractérisé en ce que** le support de mémoire comporte un matériau d'enregistrement (1) diélectrique en forme de disque, qui est dopé, au moins localement, avec des ions métalliques, sachant que sous l'effet de l'irradiation du support de mémoire par un rayon laser (6), les ions métalliques peuvent être transformés en particules métalliques et/ou en amas de particules métalliques.

3. Support de mémoire selon la revendication 1 ou 2, **caractérisé en ce que** le matériau d'enregistrement (1) utilisé est du verre.

4. Support de mémoire selon l'une quelconque des revendications précédentes, **caractérisé en ce que** le dopage aux ions métalliques est réalisé dans le matériau d'enregistrement (1) au moins sur une face, à proximité de la surface.

5. Support de mémoire selon l'une quelconque des revendications précédentes, **caractérisé en ce que** le dopage aux ions métalliques est réalisé avec des ions d'argent et/ou des ions d'or et/ou des ions de platine et/ou des ions de cuivre.

6. Support de mémoire selon l'une quelconque des revendications précédentes**, caractérisé en ce que** sur le matériau d'enregistrement (1) est déposée, au moins sur une face, une couche de matériau (3), en particulier une couche de polymère.

7. Support de mémoire selon l'une quelconque des revendications précédentes, **caractérisé en ce que** la couche de matériau (3) comporte une structure (4) optiquement fonctionnelle, qui constitue en particulier une information pour le guidage d'un rayon (6) pour l'enregistrement et/ou la lecture.

8. Support de mémoire selon l'une quelconque des revendications précédentes, **caractérisé en ce qu'**il comporte au moins deux plaques (1, 3) assemblées entre l'une à l'autre, dont au moins une comporte un matériau d'enregistrement (1) et dont une autre forme une couche de matériau (3).

9. Support de mémoire selon l'une quelconque des revendications précédentes, **caractérisé en ce qu'**un dopage par des ions métalliques à proximité de la surface est réalisé sur un matériau d'enregistrement (1), plus précisément sur la face de celui-ci orientée vers la couche de matériau (3).

10. Support de mémoire selon l'une quelconque des revendications précédentes, **caractérisé en ce que** la structure (4) fonctionnelle dans la couche de matériau (3) est réalisée sur la face orientée vers un matériau d'enregistrement (1).

11. Support de mémoire selon l'une quelconque des revendications précédentes, **caractérisé en ce qu'**il comporte une couche réfléchissante (5), qui est déposée en particulier sur la couche de matériau (3), de préférence entre la couche de matériau (3) et le matériau d'enregistrement (1).

12. Support de mémoire selon l'une quelconque des revendications précédentes, **caractérisé en ce que** les informations et les données mémorisées sont constituées d'un agencement dans l'espace de zones de matériau d'enregistrement avec et sans particules métalliques et ions métalliques.

13. Procédé d'enregistrement et/ou de lecture de données avec un support de mémoire, en particulier selon l'une quelconque des revendications précédentes, **caractérisé en ce que,** sous l'effet de l'irradiation du support ou matériau d'enregistrement par un rayonnement électromagnétique et/ou de particules, le support ou matériau d'enregistrement (1) est dopé par des ions métalliques d'un milieu de distribution disposé sur le support ou matériau d'enregistrement (1).

14. Procédé d'enregistrement et/ou de lecture de données avec un support de mémoire, en particulier selon l'une quelconque des revendications précédentes, **caractérisé en ce que,** sous l'effet de l'irradiation du support ou matériau d'enregistrement (1) par un rayonnement électromagnétique et/ou de particules dans un matériau d'enregistrement (1) diélectrique dopé au moins localement par des ions métalliques, une information est enregistrée dans le matériau d'enregistrement (1) par la formation locale de particules métalliques à partir d'ions métalliques, et/ou une information, enregistrée par des particules métalliques formées localement, est lue en transmission et/ou en réflexion par balayage du matériau d'enregistrement (1) avec le rayonnement mentionné.

15. Procédé selon l'une quelconque des revendications précédentes, **caractérisé en ce que** l'enregistrement et la lecture des informations sont effectués au moyen d'un rayon laser (6) dans le spectre visible, en particulier dans le spectre des longueurs d'onde du bleu.

16. Procédé selon l'une quelconque des revendications précédentes, **caractérisé en ce que** la formation des particules métalliques et/ou des amas de particules métalliques dans une première étape lors de l'irradiation est effectuée par la formation induite thermiquement de germes des particules métalliques par la réduction des ions métalliques, et dans une deuxième étape, il se produit une croissance des germes des particules métalliques pour former un amas de particules métalliques par l'absorption de rayonnement accrue par résonance, en particulier sous l'effet d'une résonance des plasmons de surface.

17. Procédé selon l'une quelconque des revendications précédentes, **caractérisé en ce que** les informations et les données enregistrées peuvent être supprimées sous l'effet d'un chauffage du support de mémoire (1).
